# EUROPEAN PATENT SPECIFICATION

(11) **EP 3 844 729 B1**
(45) Date of publication and mention of the grant of the patent: **13.12.2023**
(21) Application number: 19765936.0
(22) Date of filing: 28.08.2019
(51) Int. Cl.: G08B 29/18, G08B 17/00

(54) **INTEGRATED DESIGN TOOL FOR FIRE SAFETY SYSTEMS**
INTEGRIERTES ENTWURFSWERKZEUG FÜR BRANDSCHUTZSYSTEME
OUTIL DE CONCEPTION INTÉGRÉ POUR SYSTÈMES DE PROTECTION CONTRE L'INCENDIE

(30) Priority: 28.08.2018 US 201862723542 P
(43) Date of publication of application: 07.07.2021
(73) Proprietor: Carrier Corporation, Palm Beach Gardens, FL 33418 (US)
(72) Inventor: CHIANG, Nai-Yuan, Hartford, Connecticut 06108 (US); CORN, May L., Hartford, Connecticut 06108 (US); HARRIS, Peter R., Hartford, Connecticut 06108 (US); GRACE, Lester J., Ashland, Massachusetts 01721 (US)
(74) Representative: Dehns
(86) International application number: PCT/US2019/048464
(87) International publication number: WO 2020/047033

(56) References cited:
- EP-A1- 1 293 945
- JP-A- H11 250 370
- HADJISOPHOCLEOUS G V ET AL: "Performance criteria used in fire safety design", AUTOMATION IN CONSTRUCTION, ELSEVIER, AMSTERDAM, NL, vol. 8, no. 4, 1 April 1999 (1999-04-01), pages 489-501, XP004169300, ISSN: 0926-5805, DOI: 10.1016/S0926-5805(98)00096-X

## Description

Exemplary embodiments pertain to the art of fire alarm and suppression systems and more specifically to an integrated design tool for fire safety systems.

Fire alarm and fire suppression systems are typically found in commercial structures to ensure fire related safety as well as safety from other threats including smoke, heat, carbon monoxide, and the like. Commercial structures also include other systems such as heating, ventilation, and air conditioning (HVAC) systems, plumbing systems, and electrical systems that are typically designed using computer aided design (CAD) tools. Typical layout tools include a computer aided design (CAD) based user interface and a bill of materials generator. For suppliers who are quoting for both a fire detection and fire suppression system for a building, separate tools are typically needed to address the needs for designing these systems. Also, for fire-protection system designs, two separate programs are utilized to first design the piping network for a suppression system and to second evaluate if the design can be adequately applied to the current building design. For example, the suppression system will need to be assessed as to whether hydraulic performance passes system and certification agency requirements. JP H11 250370 A discloses an automated system for planning the placement of disaster prevention equipment.

According to a first aspect, the invention provides a method for integrating fire-protection systems in building design. The method includes receiving design data associated with a building, wherein the design data comprises at least one of electrical data, low voltage data, plumbing data, wall boundaries, and obstructions; and analyzing design data including electrical data, low voltage data, and plumbing data to determine an occupancy type for the building, wherein determining an occupancy type for the building comprises analyzing the electrical data, low voltage data, and plumbing data for each of a plurality of locations in the building to determine an occupancy type. One or more fire-protection protocols are accessed. One or more fire-protection designs for the building are generated based at least in part on the one or more fire-protection protocols and the design data and the one or more fire-protection designs are integrated in to the design data.

Optionally, the method may include that generating the one or more fire-protection designs for the building is based at least in part on the occupancy type for the building.

Optionally, the method may include that each of the one or more fire-protection designs comprises an implementation cost.

Optionally, the method may include that the fire-protection designs comprise a fire suppression system and a fire detection system.

Optionally, the method may include generating a bill of materials for each of the one or more fire protection designs.

Optionally, the method may include that the design data comprises specifications and occupancy classifications for the building.

Optionally, the method may include comparing the one or more fire-protection designs to the design data to generate one or more design recommendations for the building.

Optionally, the method may include that the one or more design recommendations for the building comprise at least one of a interior layout change for the building, a hydraulics system location change, and a heating, ventilation, and air condition (HVAC) system location change.

According to another aspect, the invention provides a system for integrating fire-protection systems in building design. The system includes a processor communicatively coupled to a memory, the processor configured to perform receiving design data associated with a building, wherein the design data comprises at least one of electrical data, low voltage data, plumbing data, wall boundaries, and obstructions; and analyzing design data including electrical data, low voltage data, and plumbing data to determine an occupancy type for the building, wherein determining an occupancy type for the building comprises analyzing the electrical data, low voltage data, and plumbing data for each of a plurality of locations in the building to determine an occupancy type. One or more fire-protection protocols are accessed. One or more fire-protection designs for the building are generated based at least in part on the one or more fire-protection protocols and the design data and the one or more fire-protection designs are integrated in to the design data.

Optionally, the system may include that generating the one or more fire-protection designs for the building is based at least in part on the occupancy type for the building.

According to another aspect, the invention provides a computer program product for integrating fire-protection systems in building design. The computer program product includes receiving design data associated with a building, wherein the design data comprises at least one of electrical data, low voltage data, plumbing data, wall boundaries, and obstructions; and analyzing design data including electrical data, low voltage data, and plumbing data to determine an occupancy type for the building, wherein determining an occupancy type for the building comprises analyzing the electrical data, low voltage data, and plumbing data for each of a plurality of locations in the building to determine an occupancy type. One or more fire-protection protocols are accessed. One or more fire-protection designs for the building are generated based at least in part on the one or more fire-protection protocols and the design data and the one or more fire-protection designs are integrated in to the design data.

The following descriptions should not be considered limiting in any way. With reference to the accompanying drawings, like elements are numbered alike:
FIG. 1 depicts a block diagram of a computer system for use in implementing one or more embodiments;
FIG. 2 depicts a diagram of a system for integrating fire-protection systems in building design; and
FIG. 3 depicts a diagram of a building with a system for integrating fire-protection systems in building design.

The diagrams depicted herein are illustrative. The invention is defined by the appended claims.

A detailed description of one or more embodiments of the disclosed apparatus and method are presented herein by way of exemplification and not limitation with reference to the Figures.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present invention has been described with reference to an exemplary embodiment or embodiments, it will be understood by those skilled in the art that various changes may be made and equivalents may be substituted for elements thereof without departing from the scope of the present invention, as defined by the claims. In addition, many modifications may be made to adapt a particular situation or material to the teachings of the present disclosure. Therefore, it is intended that the present invention not be limited to the particular embodiment disclosed as the best mode contemplated for carrying out this present invention, but that the present invention will include all embodiments falling within the scope of the claims.

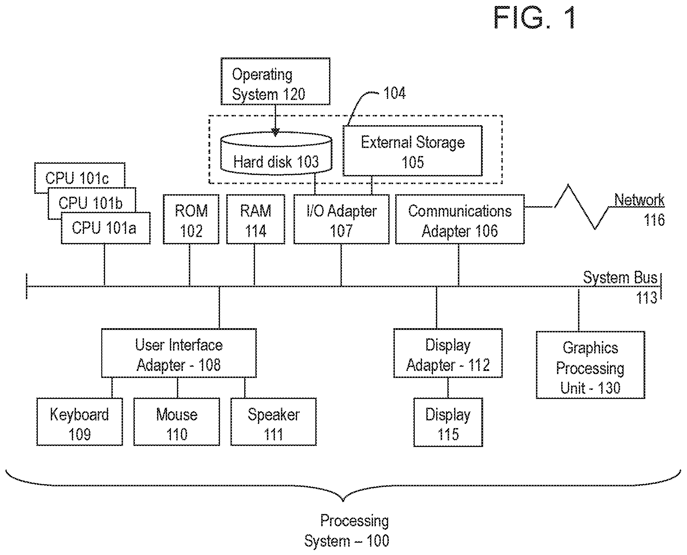

Referring to FIG. 1, there is shown an embodiment of a processing system 100 for implementing the teachings herein. In this embodiment, the system 100 has one or more central processing units (processors) 101a, 101b, 101c, etc. (collectively or generically referred to as processor(s) 101). In one embodiment, each processor 101 may include a reduced instruction set computer (RISC) microprocessor, such as, for example, one or more ARM architecture processors. Processors 101 are coupled to system memory 114 and various other components via a system bus 113. Read only memory (ROM) 102 is coupled to the system bus 113 and may include a basic input/output system (BIOS), which controls certain basic functions of system 100. The processing system 100 described herein is merely exemplary and not intended to limit the application, uses, and/or technical scope of the present disclosure, which can be embodied in various forms known in the art. The processing system 100 described herein can be utilized for any type of compute device such as, for example, a smart phone, tablet, laptop or desktop computer. The processors described herein can be utilized for server application.

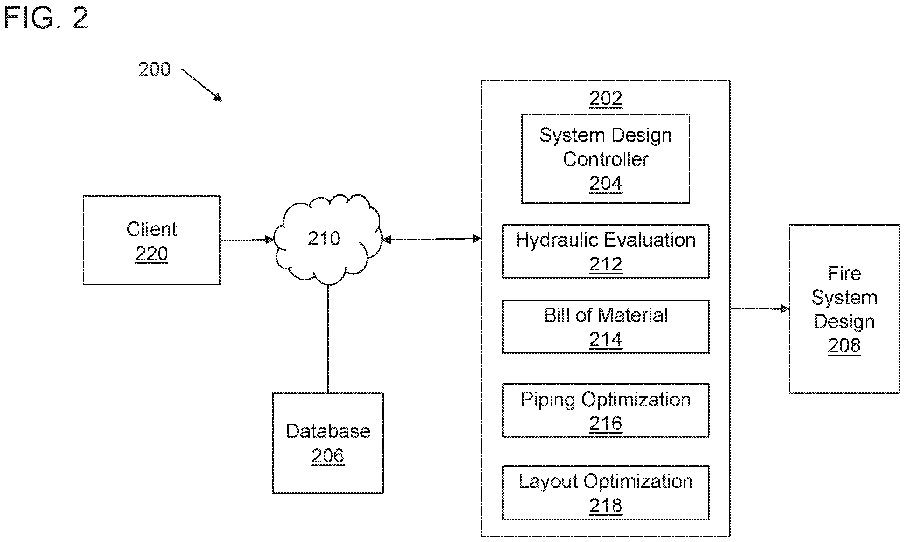

FIG. 1 further depicts an input/output (I/O) adapter 107 and a network adapter 106 coupled to the system bus 113. I/O adapter 107 may be a small computer system interface (SCSI) adapter that communicates with a hard disk 103 and/or external storage drive 105 or any other similar component. I/O adapter 107, hard disk 103, and external storage device 105 are collectively referred to herein as mass storage 104. Operating system 120 for execution on the processing system 100 may be stored in mass storage 104. A network adapter 106 interconnects bus 113 with an outside network 116 enabling data processing system 100 to communicate with other such systems. A screen (e.g., a display monitor) 115 is connected to system bus 113 by display adaptor 112, which may include a graphics adapter to improve the performance of graphics intensive applications and a video controller. In one embodiment, adapters 107, 106, and 112 may be connected to one or more I/O busses that are connected to system bus 113 via an intermediate bus bridge (not shown). Suitable I/O buses for connecting peripheral devices such as hard disk controllers, network adapters, and graphics adapters typically include common protocols, such as the Peripheral Component Interconnect (PCI). Additional input/output devices are shown as connected to system bus 113 via user interface adapter 108 and display adapter 112. A keyboard 109, mouse 110, and speaker 111 all interconnected to bus 113 via user interface adapter 108, which may include, for example, a Super I/O chip integrating multiple device adapters into a single integrated circuit, but the keyboard and mouse may be replaced by, for example, a touch-enabled display, touchpad, or other interface device. The I/O devices can be utilized as input in to the system 200 (from FIG. 2) which will be described in greater detail below. The display screen 115 can be any type of display such as a monitor associated with a computer or can be a display screen for a phone or tablet.

In exemplary embodiments, the processing system 100 includes a graphics processing unit 130. Graphics processing unit 130 is a specialized electronic circuit designed to manipulate and alter memory to accelerate the creation of images in a frame buffer intended for output to a display. In general, graphics processing unit 130 is very efficient at manipulating computer graphics and image processing, and has a highly parallel structure that makes it more effective than general-purpose CPUs for algorithms where processing of large blocks of data is done in parallel. GPUs 130 belong to a class of hardware accelerators that are configured to handle operations that are highly parallel in structure. Some or all the functionality of the system 200 optimization engines (in FIG. 2) can be offloaded on or more hardware accelerators such as, for example, the GPU 130 described herein.

Thus, as configured in FIG. 1, the system 100 includes processing capability in the form of processors 101, storage capability including system memory 114 and mass storage 104, input means such as keyboard 109 and mouse 110, and output capability including speaker 111 and display 115. In one embodiment, a portion of system memory 114 and mass storage 104 collectively store an operating system coordinate the functions of the various components shown in FIG. 1. The processing system 100 described herein is merely exemplary and not intended to limit the application, uses, and/or technical scope of the present disclosure, which can be embodied in various forms known in the art.

Turning now to an overview of the aspects of the disclosure, one or more embodiments address the shortcomings of the prior art by providing a design tool that integrates the layout and evaluation for both fire suppression and fire/smoke detection systems such that both systems can be designed in the same computer aided design interface. The design tool includes the CAD user interface, system evaluation, cost optimization, and bill of materials generator solver modules, described in greater detail below. In addition, the design tool includes a variable optimizer for a fire suppression and detection system that may optimize variables such as, for example, the discharge time, total pressure drop from source to nozzles, and the like. The system solver module can interface with multiple CAD design packages and can work on different computing platforms such as, for example, tablets, smart phones, and the like. Utilizing optimization techniques, the system can optimize device selection and placement, subject to code requirements, and costs for a given design for a building or structure. In one or more embodiments, the fire suppression system includes smoke detection systems and fire suppression systems (e.g., water-based sprinklers or water mist, clean agents, vaporizing clean agents, and/or inert gases, etc.). The design tool can enable the specification of integrated detection/suppression systems that can save on time to specify the systems and save on cost because the systems would be designed for efficient installation.

Turning now to a more detailed description of aspects of the present, FIG. 2 depicts a block diagram of a system for integrating fire-protection systems in building design according to one or more embodiments. The system 200 includes a modular solver 202 that includes a system design controller 204 that can connect to a client computing platform 220 and a network 210. Through the network, the system design controller 204 can access a database 206. In one or more embodiments, the database 206 can be local to the system design controller 204 and a network 210 connection would not be needed. In one or more embodiments, modular solver 202 includes a hydraulic evaluation engine 212, a bill of materials engine 214, a piping optimization engine 216, and a layout optimization engine 218. In one or more embodiments, the system design controller 204 can receive building design data from a client 220 and develop a fire system design 208 that can be integrated into the building design data or can be a stand-alone design. In one or more embodiments, the client 220 may include any type of computing device including but not limited to a desktop computer, laptop computer, tablet, smart phone, and the like.

In one or more embodiments, the system design controller 204 may be implemented on the processing system 100 found in FIG. 1. Additionally, the network 210 may be in wired or wireless electronic communication with one or all of the elements of the system 200. Cloud computing may supplement, support or replace some or all of the functionality of the elements of the system 200. Additionally, some or all of the functionality of the elements of system 200 may be implemented as a cloud computing node.

In one or more embodiments, the client 220 may transmit a building design file to the system design controller 204 to generate a fire system design 208. The design file may include any building modelling file type including, but not limited to, a building information modeling (BIM) file and a computer aided design (CAD) file. The design file (e.g., design data) may include layout information about the building that includes measurements of different spaces in the building. In addition, layout information may include plumbing system layouts, electrical systems layout, low voltage (e.g., Ethernet) systems layout, as well as HVAC systems layouts. The system design controller 204 may analyze the building design data received from the client 220 and may update the building design data with a fire detection/suppression system that would meet the fire detection/suppression needs for the building based on the building design and other limiting factors as described in greater detail below. This fire detection/suppression system may be incorporated in to the fire system design file 208. The system design controller 204 may access fire-protection protocols from a network 210 or local database 206 to optimize the placement of the fire-protection system. Fire-protection protocols may include fire codes and regulations, industry best practices, and company/user defined preferences or requirements for fire protection. The fire-protection system design 208 may include both a fire/smoke/carbon monoxide detection system (e.g., point sensors, aspirating sensors, video imaging) and a fire suppression system (e.g., sprinkler system, water mist, clean agent, etc.). In one or more embodiments, the system design controller 204 may also access from the database 206 bill of materials data, cost of materials and implementation data, as well as fire code and regulations data. This data can be utilized as input parameters to the hydraulic evaluation engine 212, bill of materials engine 214, piping optimization engine 216, and layout optimization engine 218. The system design controller 204 may employ an optimization algorithm to provide a fire system design 208 that meets the requirements of the client 220. For example, a customer could provide design data for a proposed building and request a sprinkler system that meets the fire code in the local jurisdiction and is within a cost range suitable for the customer. The optimization algorithm may provide a fire system design 208 that meets the customer requirements and, optionally, integrates the fire system design 208 in to the presented design file from the client 220. In one or more embodiments, the system design controller 204 may provide multiple fire system designs 208 for selection by a customer that meet the requirements and also provide different metrics for cost, performance, bills of material, and the like.

In one or more embodiments, system design controller 204 can interface with the client 220 running an application through an API. The client application can be any type of a computer aided design (CAD) application that is utilized to create drawings representative of buildings or sites that may need installation of a fire detection/suppression system. The CAD drawings can be a design file for a potential or existing site requiring a fire suppression system and/or a fire detection system. The CAD drawings can be analyzed by the system design controller 204 to create the fire system design data 208. The fire system design data 208 might be in a format similar or the same as the CAD design drawings presented by the client 220. Or the fire system design data 208 may be a listing of materials and costs associated with installing a fire detection/suppression system. The format of the fire system design data 208 can be specified by the client 220.

In one or more embodiments, the design data, presented by the client 220 to the system design controller 204, may include occupancy classifications as well as intended usage for areas of the building or site that can be analyzed and compared to fire protection protocols to assist with the fire system design 208. As mentioned above, fire protection protocols include fire codes and fire regulations for the location associated with a building or site. In addition, fire protection protocols may include industry best practices of building types and occupancy types. For example, a server room in a building would not typically utilize a water sprinkler system and would require a different fire suppression agent than other parts of the building such as an office. Also, hazard types for the building may be included in the design data that can be incorporated into the fire system design 208 to meet requirements. In addition to occupancy classifications and intended use, existing systems such as plumbing, HVAC, and electrical can be included in the design data as a potential requirement for the optimization algorithm. For example, placement of sprinkler nozzles and/or smoke detection devices might be blocked by existing HVAC features in the building design. In this example, optimal placement of a sprinkler nozzle can be over ruled by other systems and the sprinkler would be placed in a location that meets safety requirements but does not necessarily amount to optimal placement. In one or more embodiments, costs data can be incorporated in the design data that is associated with the HVAC, electrical, and plumbing systems. A cost benefit analysis can be performed by the system design controller 204 to identify potential changes to the design data file that would save cost by allowing for more cost effective placement of the fire safety system by adjusting the design of other system in the building. For example, if moving one or two ducts in an HVAC system would reduce costs of the fire safety system by more than the cost of moving the one or two ducts, the fire system design 208 would include this recommendation for the design file and identify the potential costs savings. In one or more embodiments, the HVAC, electrical, and plumbing system associated costs for implementation and/or adjustment can be calculated by the system design controller 204 with data accessed through the database 208. For example, the system design controller 204 can receive a design file with no cost information and later calculate estimates of costs based on historical cost data for building design and utilize the estimated costs to generate recommendation (e.g., adjustments to the current design to save money). In addition, adjustments to the building layout can be included in the recommendations.

In one or more embodiments, the system design controller 204 can analyze the design data to infer occupancy classifications and/or intended uses. For example, a location in the building that shows a number of low voltage (e.g. Ethernet) ports in a single room could be inferred that the room will house a number of computers, servers, and the like. Based on this inference, the system design controller 204 can adjust the fire suppression agent used for the inferred intended usage of the room.

In one or more embodiments, addition requirements can be utilized when optimizing the fire system design 208 such as geographic location of the building, environmental conditions in and around the building, and land information where the building is to be built. For example, when placing a hydraulic system for usage in a fire suppression system, the system design controller 204 can analyze information about the surrounding land around the building such as soil conditions, access to power, ease of access for maintenance, noise considerations, and the like. Soil conditions could affect the building of a hydraulic system in certain areas around the building for example. Some additional requirements can include parking lot/deck information, landscaping around the building, and other aesthetic features of the building. These additional requirements can be incorporated in to the optimization for the fire system design 208 by the system design controller 204.

In one or more embodiments, the system design controller 204 utilizes an optimization algorithm for fire system requirements such as, for example, nozzle type for a sprinkler head, piping type, and piping size. The optimization algorithm can be any type of optimization algorithm that can utilize linear or non-linear programing or the like. One or more optimization algorithms may be implemented on the hydraulic evaluation engine 212 to optimize water pressure through different piping options. The piping optimization engine 212 may utilize one or more optimization algorithms for placement of the piping through the building or site. For costs optimization, the bill of materials engine 214 can employ one or more optimization algorithms aimed at reducing the total costs of materials and/or installation costs for a fire detection/suppression system. The layout optimization engine 218 may utilize one or more optimization algorithms for designing the layout for each room or location with a site or building.

In one or more embodiments, the fire protection system includes fire detection systems that are also included in the design by the system design controller 202. Similar to the suppression network, the detection wiring network can be evaluated on an electrical basis with resistors and current being an analog to hydraulics evaluation of friction and flow through pipes. In another embodiment, an aspirating detection system relies on taking in air through holes drilled into a pipe network. Here, the pipe size, layout, and hole sizes are evaluated on a hydraulics basis to ensure that enough sample is drawn into the pipes and channeled to a detector for examination.

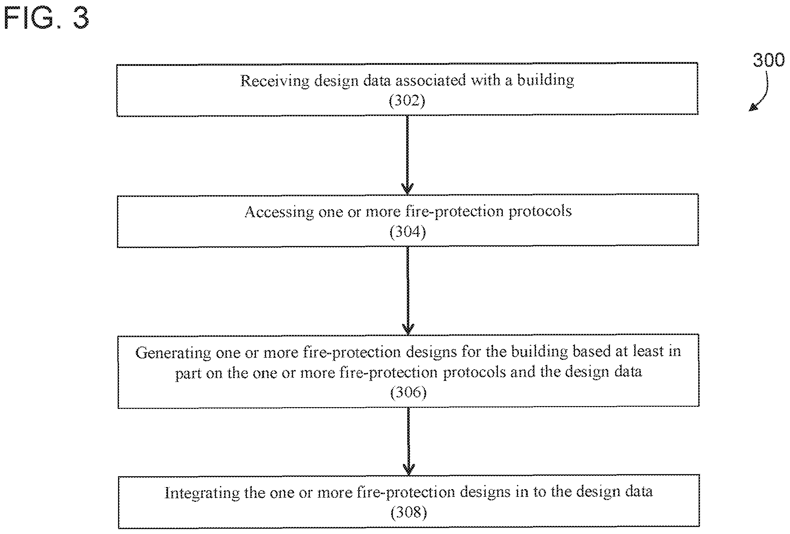

FIG. 3 depicts a flow diagram of a method for integrating fire-protection systems in building design according to one or more embodiments. The method 300 includes receiving design data associated with a building, as shown in block 302. At block 304, the method 300 includes accessing one or more fire-protection protocols. The method 300, at block 306, includes generating one or more fire-protection designs for the building based at least in part on the one or more fire-protection protocols and the design data. And at block 308, the method 300 includes integrating the one or more fire-protection designs in to the design data.

Additional processes may also be included. It should be understood that the processes depicted in FIG. 3 represent illustrations and that other processes may be added or existing processes may be removed, modified, or rearranged without departing from the scope of the appended claims.

A detailed description of one or more embodiments of the disclosed apparatus are presented herein by way of exemplification and not limitation with reference to the Figures.

While the present disclosure has been described with reference to an exemplary embodiment or embodiments, it will be understood by those skilled in the art that various changes may be made and equivalents may be substituted for elements thereof without departing from the scope of the present invention, as defined by the claims. In addition, many modifications may be made to adapt a particular situation or material to the teachings of the present invention without departing from the scope of the claims. Therefore, it is intended that the present invention not be limited to the particular embodiment disclosed as the best mode contemplated for carrying out this present invention, but that the present invention will include all embodiments falling within the scope of the claims.

## Claims

1. A computer-implemented method for integrating fire-protection systems in building design, the method comprising:
receiving design data associated with a building (302), wherein the design data comprises at least one of electrical data, low voltage data, plumbing data, wall boundaries, and obstructions;
analyzing design data including electrical data, low voltage data, and plumbing data to determine an occupancy type for the building, wherein determining an occupancy type for the building comprises:
analyzing the electrical data, low voltage data, and plumbing data for each of a plurality of locations in the building to determine an occupancy type;
accessing one or more fire-protection protocols (304);
generating one or more fire-protection designs for the building based at least in part on the one or more fire-protection protocols and the design data (306); and
integrating the one or more fire-protection designs in to the design data (308).

2. The computer-implemented method of Claim 1, wherein generating the one or more fire-protection designs for the building is based at least in part on the occupancy type for the building.

3. The computer-implemented method of Claim 1, wherein each of the one or more fire-protection designs comprises an implementation cost.

4. The computer-implemented method of Claim 1, wherein the fire-protection designs comprise a fire suppression system and a fire detection system.

5. The computer-implemented method of Claim 1 further comprising generating a bill of materials for each of the one or more fire protection designs.

6. The computer-implemented method of Claim 1, wherein the design data comprises specifications and occupancy classifications for the building.

7. The computer-implemented method of Claim 1 further comprising:
comparing the one or more fire-protection designs to the design data to generate one or more design recommendations for the building.

8. The computer-implemented method of Claim 7, wherein the one or more design recommendations for the building comprise at least one of a interior layout change for the building, a hydraulics system location change, and a heating, ventilation, and air condition (HVAC) system location change.

9. A system for integrating fire-protection systems in building design, the system comprising:
a processor (101) communicatively coupled to a memory (114), the processor configured to:
receive design data associated with a building, wherein the design data comprises at least one of electrical data, low voltage data, plumbing data, wall boundaries, and obstructions;
analyze design data including electrical data, low voltage data, and plumbing data to determine an occupancy type for the building, wherein determining an occupancy type for the building comprises:
analyzing, by the processor, the electrical data, low voltage data, and plumbing data for each of a plurality of locations in the building to determine an occupancy type;
access one or more fire-protection protocols;
generate one or more fire-protection designs for the building based at least in part on the one or more fire-protection protocols and the design data; and
integrate the one or more fire-protection designs in to the design data.

10. The system of Claim 9, wherein generating the one or more fire-protection designs for the building is based at least in part on the occupancy type for the building.

11. A computer program product for integrating fire-protection systems in building design, the computer program product comprising a computer readable storage medium having program instructions embodied therewith, the program instructions executable by a processor (101) to cause the processor to perform the method of claim 1.

## Patentansprüche

1. Computerimplementiertes Verfahren zum Integrieren von Brandschutzsystemen in einen Gebäudeentwurf, wobei das Verfahren umfasst:
Empfangen von Entwurfsdaten, die einem Gebäude (302) zugeordnet sind, wobei die Entwurfsdaten mindestens eins von elektrischen Daten, Niederspannungsdaten, Rohrverlegungsdaten, Wandgrenzen und Hindernissen umfassen;
Analysieren von Entwurfsdaten, die elektrische Daten, Niederspannungsdaten und Rohrverlegungsdaten beinhalten, um einen Belegungstyp für das Gebäude zu bestimmen, wobei das Bestimmen eines Belegungstyps für das Gebäude umfasst:
Analysieren der elektrischen Daten, der Niederspannungsdaten und der Rohrverlegungsdaten für jeden von einer Vielzahl von Orten in dem Gebäude, um einen Belegungstyp zu bestimmen;
Zugreifen auf ein oder mehrere Brandschutzprotokolle (304);
Erzeugen eines oder mehrerer Brandschutzentwürfe für das Gebäude mindestens teilweise auf Grundlage des einen oder der mehreren Brandschutzprotokolle und der Entwurfsdaten (306); und
Integrieren des einen oder der mehreren Brandschutzentwürfe in die Entwurfsdaten (308).

2. Computerimplementiertes Verfahren nach Anspruch 1, wobei das Erzeugen des einen oder der mehreren Brandschutzentwürfe für das Gebäude mindestens teilweise auf dem Belegungstyp für das Gebäude basiert.

3. Computerimplementiertes Verfahren nach Anspruch 1, wobei jeder von dem einen oder den mehreren Brandschutzentwürfen einen Implementierungsaufwand umfasst.

4. Computerimplementiertes Verfahren nach Anspruch 1, wobei die Brandschutzentwürfe ein Brandunterdrückungssystem und ein Brandmeldesystem umfassen.

5. Computerimplementiertes Verfahren nach Anspruch 1, ferner umfassend Erzeugen einer Materialliste für jeden von dem einen oder den mehreren Brandschutzentwürfen.

6. Computerimplementiertes Verfahren nach Anspruch 1, wobei die Entwurfsdaten Spezifikationen und Belegungsklassifikationen für das Gebäude umfassen.

7. Computerimplementiertes Verfahren nach Anspruch 1, ferner umfassend:
Vergleichen des einen oder der mehreren Brandschutzentwürfe mit den Entwurfsdaten, um eine oder mehrere Entwurfsempfehlungen für das Gebäude zu erzeugen.

8. Computerimplementiertes Verfahren nach Anspruch 7, wobei die eine oder mehreren Entwurfsempfehlungen für das Gebäude mindestens eine von einer Änderung des Innenausbaus für das Gebäude, einer Änderung des Standorts eines Hydrauliksystems und einer Änderung des Standorts eines Heizungs-, Lüftungs- und Klimasystems (HVAC) umfassen.

9. System zum Integrieren von Brandschutzsystemen in einen Gebäudeentwurf, wobei das System umfasst:
einen Prozessor (101), der kommunikationstechnisch an einen Speicher (114) gekoppelt ist, wobei der Prozessor konfiguriert ist zum:
Empfangen von Entwurfsdaten, die einem Gebäude zugeordnet sind, wobei die Entwurfsdaten mindestens eins von elektrischen Daten, Niederspannungsdaten, Rohrverlegungsdaten, Wandgrenzen und Hindernissen umfassen;
Analysieren von Entwurfsdaten, die elektrische Daten, Niederspannungsdaten und Rohrverlegungsdaten beinhalten, um einen Belegungstyp für das Gebäude zu bestimmen, wobei das Bestimmen eines Belegungstyps für das Gebäude umfasst:
Analysieren der elektrischen Daten, der Niederspannungsdaten und der Rohrverlegungsdaten für jeden von einer Vielzahl von Orten in dem Gebäude durch den Prozessor, um einen Belegungstyp zu bestimmen;
Zugreifen auf ein oder mehrere Brandschutzprotokolle;
Erzeugen eines oder mehrerer Brandschutzentwürfe für das Gebäude mindestens teilweise auf Grundlage des einen oder der mehreren Brandschutzprotokolle und der Entwurfsdaten; und
Integrieren des einen oder der mehreren Brandschutzentwürfe in die Entwurfsdaten.

10. System nach Anspruch 9, wobei das Erzeugen des einen oder der mehreren Brandschutzentwürfe für das Gebäude mindestens teilweise auf dem Belegungstyp für das Gebäude basiert.

11. Computerprogrammprodukt zum Integrieren von Brandschutzsystemen in einen Gebäudeentwurf, wobei das Computerprogrammprodukt ein computerlesbares Speichermedium mit Programmanweisungen umfasst, die damit verkörpert sind, wobei die Programmanweisungen durch einen Prozessor (101) ausführbar sind, um den Prozessor zu veranlassen, das Verfahren nach Anspruch 1 auszuführen.

## Revendications

1. Procédé mis en œuvre par ordinateur pour intégrer des systèmes de protection contre l'incendie dans une conception de bâtiment, le procédé comprenant :
la réception de données de conception associées à un bâtiment (302), dans lequel les données de conception comprennent au moins l'une parmi des données électriques, des données basses tension, des données de plomberie, des limites de paroi et des obstructions ;
l'analyse de données de conception comportant des données électriques, des données basse tension et des données de plomberie pour déterminer un type d'occupation pour le bâtiment, dans lequel la détermination d'un type de d'occupation pour le bâtiment comprend :
l'analyse des données électriques, des données basse tension et des données de plomberie pour chacun d'une pluralité d'emplacements dans le bâtiment pour déterminer un type d'occupation ;
l'accès à un ou plusieurs protocoles de protection contre l'incendie (304) ;
la génération d'une ou de plusieurs conceptions de protection contre l'incendie pour le bâtiment sur la base au moins en partie des un ou plusieurs protocoles de protection contre l'incendie et des données de conception (306) ; et
l'intégration des une ou plusieurs conceptions de protection contre l'incendie dans les données de conception (308).

2. Procédé mis en œuvre par ordinateur selon la revendication 1, dans lequel la génération des une ou plusieurs conceptions de protection contre l'incendie pour le bâtiment est basée au moins en partie sur le type d'occupation pour le bâtiment.

3. Procédé mis en œuvre par ordinateur selon la revendication 1, dans lequel chacune des une ou plusieurs conceptions de protection contre l'incendie comprend un coût de mise en œuvre.

4. Procédé mis en œuvre par ordinateur selon la revendication 1, dans lequel les conceptions de protection contre l'incendie comprennent un système d'extinction d'incendie et un système de détection d'incendie.

5. Procédé mis en œuvre par ordinateur selon la revendication 1 comprenant en outre la génération d'une nomenclature pour chacune des une ou plusieurs conceptions de protection contre l'incendie.

6. Procédé mis en œuvre par ordinateur selon la revendication 1, dans lequel les données de conception comprennent des spécifications et des classifications d'occupation pour le bâtiment.

7. Procédé mis en œuvre par ordinateur selon la revendication 1 comprenant en outre :
la comparaison des une ou plusieurs conceptions de protection contre l'incendie aux données de conception pour générer une ou plusieurs recommandations de conception pour le bâtiment.

8. Procédé mis en œuvre par ordinateur selon la revendication 7, dans lequel les une ou plusieurs recommandations de conception pour le bâtiment comprennent au moins l'un parmi un changement d'aménagement intérieur pour le bâtiment, un changement d'emplacement de système hydraulique et un changement d'emplacement de système de chauffage, de ventilation et climatisation (HVAC).

9. Système pour intégrer des systèmes de protection contre l'incendie dans une conception de bâtiment, le système comprenant :
un processeur (101) couplé en communication à la mémoire (114), le processeur étant configuré pour :
recevoir des données de conception associées à un bâtiment, dans lequel les données de conception comprennent au moins l'une parmi des données électriques, des données basses tension, des données de plomberie, des limites de paroi et des obstructions ;
analyser des données de conception comportant des données électriques, des données basse tension et des données de plomberie pour déterminer un type d'occupation pour le bâtiment, dans lequel la détermination d'un type de d'occupation pour le bâtiment comprend :
l'analyse, par le processeur, des données électriques, des données basse tension et des données de plomberie pour chacun d'une pluralité d'emplacements dans le bâtiment pour déterminer un type d'occupation ;
accéder à un ou plusieurs protocoles de protection contre l'incendie ;
générer une ou plusieurs conceptions de protection contre l'incendie pour le bâtiment sur la base au moins en partie des un ou plusieurs protocoles de protection contre l'incendie et des données de conception ; et
intégrer les une ou plusieurs conceptions de protection contre l'incendie dans les données de conception.

10. Système selon la revendication 9, dans lequel la génération des une ou plusieurs conceptions de protection contre l'incendie pour le bâtiment est basée au moins en partie sur le type d'occupation pour le bâtiment.

11. Produit de programme informatique pour intégrer des systèmes de protection contre l'incendie dans une conception de bâtiment, le produit de programme informatique comprenant un support de stockage lisible par ordinateur ayant des instructions de programme incorporées à celui-ci, les instructions de programme étant exécutables par un processeur (101) pour amener le processeur à exécuter le procédé selon la revendication 1.
